## Europäisches Patentamt
## European Patent Office
## Office européen des brevets

(19)

(11) Numéro de publication: **0 155 197**
**B1**

(12)

# FASCICULE DE BREVET EUROPEEN

(45) Date de publication du fascicule du brevet:
20.12.89

(51) Int. Cl.⁴: **G 01 R 19/00**

(21) Numéro de dépôt: 85400110.4

(22) Date de dépôt: 23.01.85

(54) Appareil de mesure de courants faibles à grande dynamique.

(30) Priorité: 27.01.84 FR 8401317

(43) Date de publication de la demande:
18.09.85 Bulletin 85/38

(45) Mention de la délivrance du brevet:
20.12.89 Bulletin 89/51

(84) Etats contractants désignés:
CH DE GB IT LI NL

(56) Documents cités:
DE-A- 3 022 196

ELECTRONIQUE INDUSTRIELLE, no. 133, mai 1970, pages 276-282, Paris, FR; BURKHART et al.: "Appareils originaux pour la mesure des courants faibles"
INSTRUMENTS & EXPERIMENTAL TECHNIQUES, volume 20, no. 1-2, janvier-février 1977, pages 168-171, New York, US; V.G. KOZLOV et al.: "Electrometer amplifier with automatic range switching"
TECHNISCHES MESSEN, volume 49, no. 4, avril 1982, pages 149-158, Munich, DE; W. MAHR: "Messen und verarbeiten von Ladungssignalen piezoelektrischer Aufnehmer"

(73) Titulaire: COMMISSARIAT A L'ENERGIE ATOMIQUE, 31/33, rue de la Fédération, F-75015 Paris (FR)
(84) Etats contractants désignés: CH DE GB IT LI

(73) Titulaire: SOCIETE D'ETUDES INDUSTRIELLES DE VILLEJUIF, S.E.I.V., 21 rue Georges le Bigot, F-94800 Villejuif (FR)
(84) Etats contractants désignés: NL

(72) Inventeur: Rabeyrolles, Serge, 1, Allée des Prats, F-33610 Cestas (FR)

(74) Mandataire: Mongrédien, André et al, c/o BREVATOME 25, rue de Ponthieu, F-75008 Paris (FR)

(56) Documents cités: (suite)
IBM TECHNICAL DISCLOSURE BULLETIN, volume 25, no. 8, janvier 1983, pages 4468-4469, New York, US; A. BRUNIN: "Improved use of operational amplifiers for electrometer applications"
JOURNAL OF PHYSICS E; SCIENTIFIC INSTRUMENTS, volume 8, no. 5, 1975, pages 398-402, Londres, GB; T. ANDERSSON et al.: "A wide range resistance meter with logarithmic output for continuous measurements over several decades"

## Description

La présente invention concerne un appareil de mesure de courants faibles à grande dynamique. Cet appareil est adapté à la mesure de courants dont les valeurs les plus faibles peuvent être de l'ordre de $10^{-14}$ A. Un tel appareil est utilisé notamment en physique, en biologie, dans le domaine spatial et en radioprotection.

Pour répondre aux besoins dans les domaines énumérés ci-dessus, un appareil de mesure doit généralement permettre d'effectuer une mesure très précise, mais doit également couvrir une large gamme. Il est donc nécessaire de prévoir un changement de sensibilité mais il est interdit d'envisager une commutation manuelle de celle-ci.

Le demandeur a décrit un tel appareil dans le brevet français PV 144 111 du 15 mars 1968 (publié le 19.10.1970 sous le numéro FR-A-1 602 171) pour «Appareil de mesure de courant haute tension continu, à grande dynamique».

Cet appareil comporte essentiellement un adaptateur d'entrée symétrique à impédance très élevée, une chaîne d'amplification couplée à la sortie de l'adaptateur et associée à une chaîne de contre-réaction linéaire et à une chaîne de contre-réaction logarithmique comportant au moins un premier élément logarithmique. Un second élément logarithmique de compensation en température identique au premier et associé à la chaîne d'amplification, un dispositif de lecture en sortie des circuits de la chaîne d'amplification, au moins un circuit à seuil couplé à la sortie de la chaîne d'amplification et à l'entrée d'un circuit de commande d'organes de commutation de gamme par l'intermédiaire d'une porte à condition d'interdiction dont l'entrée est couplée à un circuit à retard, des éléments de tarage et décalage du dispositif de lecture associés à la chaîne d'amplification, les organes de commutation provoquant au moins la commutation de la chaîne de contre-réaction linéaire au niveau du seuil du circuit à seuil.

Il est connu d'utiliser comme adaptateur d'entrée symétrique à haute impédance, pour les appareils de mesure du type considéré, un montage symétrique à deux transistors à électrodes de commande isolées associés à deux transistors ordinaires. Un tel montage est décrit dans le certificat d'addition n° PV 135 544 déposé par le demandeur le 10 janvier 1968 (et publié le 25.04.69 sous le numéro FR-E-93 644) pour «Appareil de mesure logarithmique de quantités de charges délivrées par une chambre d'ionisation».

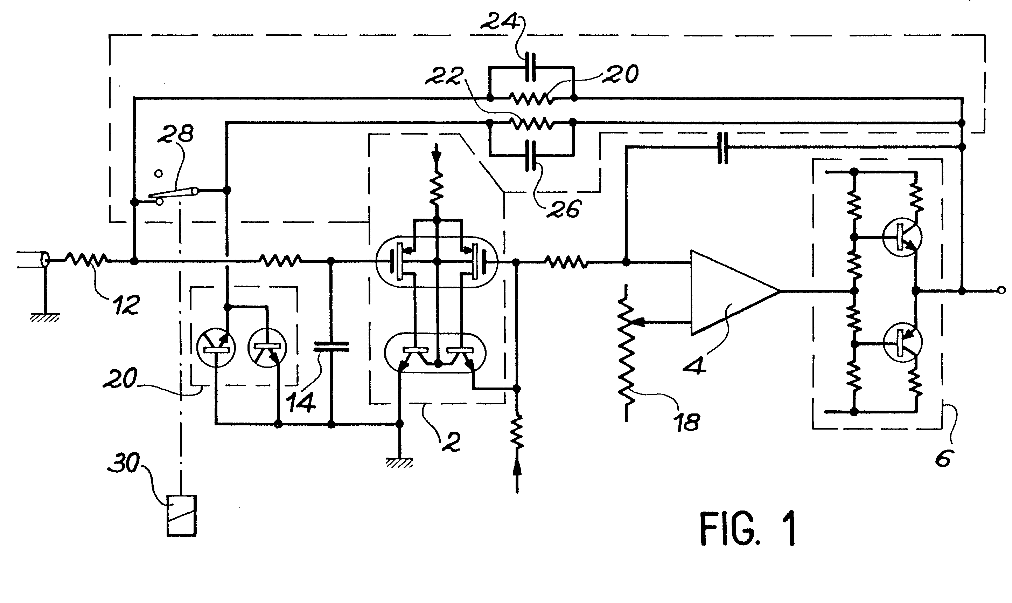

On a représenté sur la figure 1 un dessin schématique illustrant un mode de réalisation d'un préamplificateur de courants faibles suivant les enseignements des deux brevets cités.

Ce préamplificateur comprend principalement un adaptateur d'impédance 2, un amplificateur 4 et un étage symétrique de deux transistors 6 pour assurer un courant de sortie suffisant. Ce préamplificateur reçoit en entrée le courant faible à mesurer et provenant par exemple d'une chambre d'ionisation. Ce courant est par exemple compris

entre $10^{-14}$ et $10^{-11}$ A. Le courant de sortie délivré par cet amplificateur est de l'ordre de 5 mA.

L'adaptateur d'impédance 2 est protégé en entrée par un ensemble 10 de diodes et par un réseau RC comprenant une résistance 12 de forte valeur et un condensateur 14. En raison de sa structure symétrique, cet adaptateur d'impédance 2 est stable en température.

L'amplification d'un courant d'entrée très faible est délicate. Elle nécessite un adaptateur d'impédance 2 ayant le plus faible courant de fuite possible (courant faible à mesurer) et une chaîne de contre-réaction 8 de grande précision et de grande stabilité. Un moyen 18 de réglage du zéro de l'amplificateur 4 en l'absence de signal en entrée (réglage d'«offset») est prévu sur l'entrée non inverseuse de l'amplificateur.

La chaîne de contre-réaction 8 de l'amplificateur comporte deux voies en parallèle de sensibilité différente. La valeur de la résistance de chaque voie détermine le gain du préamplificateur. La voie de plus forte sensibilité comprend une résistance 20 de très forte valeur. La voie de plus faible sensibilité comprend une résistance 22 moins forte, par exemple de valeur au moins 100 fois plus faible. Des condensateurs 24 et 26 sont disposés en parallèle avec ces résistances. La plus faible sensibilité est obtenue en reliant en parallèle les deux voies. Ceci est réalisé par un interrupteur 28 commandé par un relais 30 à haut isolement.

L'objet de l'invention est un perfectionnement à l'appareil de mesure décrit dans le brevet français déjà cité. Ce perfectionnement porte principalement sur le préamplificateur de l'appareil de mesure.

De manière précise, l'appareil de mesure de courants faibles à grande dynamique selon l'invention comprend un préamplificateur linéaire, un moyen d'amplification logarithmique recevant le signal délivré par le préamplificateur, un moyen d'alarme déclenchant un signal d'alarme lorsque le signal délivré par le moyen d'amplification logarithmique est supérieur à un niveau donné, et un moyen de lecture du signal délivré par le moyen d'amplification logarithmique.

Le préamplificateur comprend une entrée recevant le faible courant à mesurer et une sortie délivrant un signal amplifié fonction de ce courant à mesurer, ledit signal étant appliqué à l'entrée du moyen d'amplification logarithmique.

L'appareil se caractérise en ce que le préamplificateur comprend en série un premier amplificateur dont une entrée correspond à l'entrée du préamplificateur et étant formé d'un amplificateur différentiel doté d'une chaîne de contre-réaction linéaire, l'entrée inverseuse de l'amplificateur différentiel étant directement reliée à l'entrée du préamplificateur, ledit amplificateur fournissant la majorité du gain dudit préamplificateur, et un second amplificateur recevant le signal de sortie du premier amplificateur, cet amplificateur étant pour cela placé entre la sortie du premier amplificateur et la sortie du préamplificateur afin d'assurer un rôle de tampon, ce second amplificateur fournissant en outre un gain de quelques unités; la chaîne de contre-réaction linéaire de l'amplificateur différentiel étant à très haute impédance, le second amplificateur étant doté d'une chaîne de contre-réaction linéaire d'impédance beaucoup plus faible, un moyen de réglage du zéro et un moyen de contrôle du gain général de l'appareil étant en outre prévus sur le premier amplificateur.

La plus grande partie du gain du préamplificateur est obtenue par le premier amplificateur. Le gain apporté par le second amplificateur est seulement de l'ordre de quelques unités. Ce report d'une partie du gain sur un second amplificateur, pour faible qu'il soit, est important. En effet, dans les appareils de mesure de courants faibles connus, l'amplificateur est unique et travaille à la limite de ses performances. Ceci se traduit notamment par un courant de fuite relativement important. Dans l'appareil de l'invention au contraire, le report d'une partie du gain sur le second amplificateur permet de diminuer les contraintes sur l'amplificateur d'entrée, ce qui contribue à limiter le courant de fuite.

Selon une caractéristique importante de l'appareil selon l'invention, la chaîne de contre-réaction du premier amplificateur comporte une gamme d'impédances commutées par un moyen de seuillage recevant en entrée le signal délivré par le moyen d'amplification logarithmique.

Selon une autre caractéristique de l'appareil selon l'invention, le moyen de réglage du zéro comporte un moyen de préréglage et un moyen d'ajustage fin, ledit moyen d'ajustage fixant le potentiel appliqué sur l'entrée non inverseuse du premier amplificateur.

Selon une autre caractéristique de l'appareil selon l'invention, le premier amplificateur est alimenté par une tension inférieure à la tension nominale.

Les caractéristiques et avantages de l'invention ressortiront mieux de la description qui va suivre donnée à titre illustratif mais non limitatif en référence aux dessins annexés, sur lesquels:

– la figure 1, déjà décrite, représente schématiquement un mode de réalisation du préamplificateur d'un appareil de mesure de courants faibles selon l'art connu,

– la figure 2 représente schématiquement l'appareil de mesure selon l'invention,

– la figure 3 représente un mode de réalisation du préamplificateur de l'appareil selon l'invention,

– la figure 4 représente un mode de réalisation du moyen d'amplification logarithmique de l'appareil selon l'invention,

– la figure 5 représente un mode de réalisation du moyen de seuillage de l'appareil selon l'invention.

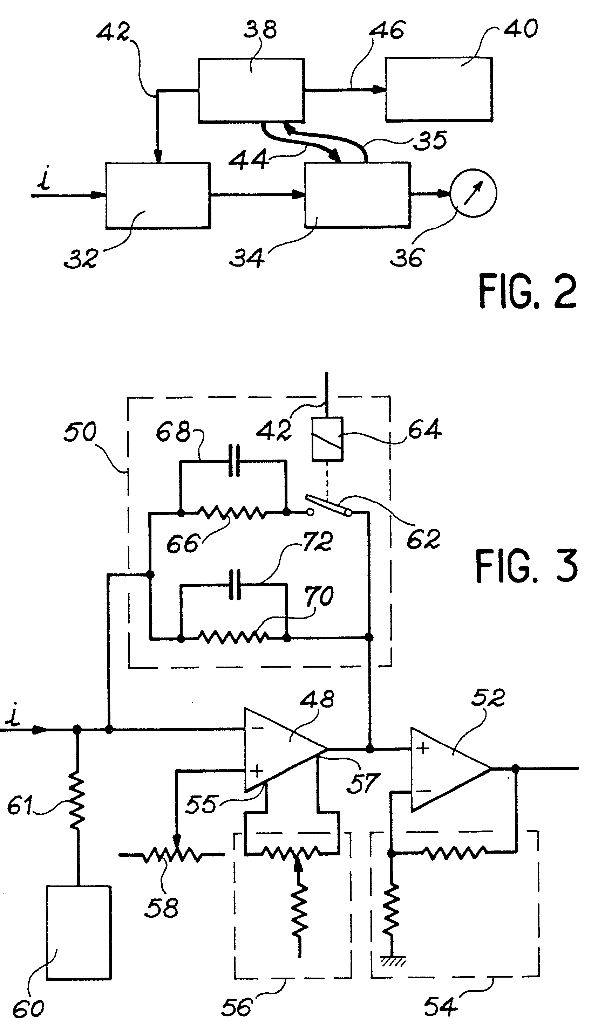

On a représenté sur la figure 2 un dessin synoptique de l'appareil de mesure selon l'invention. Il comprend un préamplificateur 32, un moyen d'amplification logarithmique 34, un moyen de lecture 36, un moyen de seuillage 38 et un moyen d'alarme 40.

Le préamplificateur 32 reçoit le faible courant i à amplifier. Il délivre un signal de tension proportionnel à ce courant i. Ce signal est appliqué sur l'entrée du moyen d'amplification logarithmique 34 qui délivre un signal de tension proportionnel au logarithme du courant du signal reçu. Ce signal est délivré au moyen de lecture 36 et un signal proportionnel est délivré au moyen de seuillage 38 par la connexion 35. Ce moyen de seuillage assure la comparaison entre le signal issu du moyen d'amplification logarithmique 34 et un niveau de référence déterminant le déclenchement de l'alarme. Ce moyen possède également un circuit à double seuil qui permet la commande par la connexion 42 du changement de gamme automatique de la chaîne de contre-réaction du préamplificateur 32. Le décalage du gain du moyen d'amplification logarithmique est effectué simultanément par un signal de commande émis sur la connexion 44.

Le moyen d'alarme 40 déclenche une alarme sur réception d'un signal reçu du moyen de seuillage 38 par une connexion 46. Le moyen d'alarme peut comprendre également des moyens vérifiant le fonctionnement correct de l'appareil (alimentation, ...). L'alarme déclenchée peut être sonore et/ou visuelle. Elle peut être immédiate ou retardée.

Le préamplificateur de la figure 3 comprend principalement un premier amplificateur différentiel 48 à très faible courant de fuite muni d'une chaîne de contre-réaction linéaire 50 à très haute impédance et d'un second amplificateur 52 muni d'une chaîne de contre-réaction linéaire 54. Un moyen 56 de préréglage du zéro et un moyen 58 d'ajustage fin de ce zéro sont en outre prévus sur l'amplificateur différentiel 48.

Le gain en tension du second amplificateur est de l'ordre de quelques unités, par exemple égal à 2. La plus grande partie du gain du préamplificateur est fournie par le premier amplificateur qui reçoit un courant de $10^{-14}$ à $10^{-8}$ A et qui délivre un signal de tension qui peut atteindre quelques volts.

Le préamplificateur comprend enfin un moyen de test 60 permettant de vérifier le gain de l'appareil. Ce moyen 60 injecte un courant calibré grâce à la résistance 61 dans l'entrée inverseuse de l'amplificateur 48. La vérification du gain est faite par lecture du moyen 36 (figure 2).

A titre d'exemple, on peut utiliser comme amplificateur 48 l'amplificateur ICH8500A de INTERSIL.

Enfin, pour limiter le courant de fuite en entrée, il peut paraître utile de sous-alimenter le premier amplificateur. Ceci n'est possible, pour un gain du préamplificateur fixé, que si le second amplificateur rattrape le gain perdu par le premier amplificateur du fait de cette sous-alimentation.

Le courant faible à amplifier est reçu sur l'entrée inverseuse de l'amplificateur différentiel 48 qui délivre en sortie un signal de tension.

Le gain de cet amplificateur est fonction de la chaîne de contre-réaction 50. Compte tenu du faible niveau du signal de courant reçu par l'amplificateur, l'impédance de cette chaîne 50 doit être très importante pour que le signal de tension délivré par l'amplificateur 48 ait un niveau de quelques volts. L'impédance de cette chaîne 50 est donc par exemple au moins de $10^{10}$ ohms.

L'amplificateur différentiel 52 reçoit le signal de tension délivré par l'amplificateur 48 sur son entrée non inverseuse. Il comporte une chaîne de contre-réaction 54 qui détermine son gain. L'impédance de cette chaîne 54 est très inférieure à l'impédance de la chaîne 50. Le rôle de l'amplificateur 52 est en effet essentiellement un rôle de tampon entre la sortie de l'amplificateur 48 et les autres moyens de l'appareil de mesure situés en aval.

Le réglage du zéro de l'amplificateur 48 est différent du réglage du zéro de l'amplificateur de la figure 1. Il comporte un premier moyen de réglage 56 qui peut être préréglé par exemple à la construction du préamplificateur et un moyen d'ajustage 58 accessible à l'utilisateur qui permet d'affiner le réglage du zéro. Le moyen de réglage 56 est disposé entre les bornes adéquates 55 et 57 de l'amplificateur 48. Le moyen d'ajustage 58 est relié à l'entrée non inverseuse de l'amplificateur 48.

Pour que ce réglage du zéro soit possible, il faut que l'amplificateur 52 ait une très faible tension d'offset, par exemple inférieure à 100 µV. A titre d'exemple, on peut utiliser l'amplificateur OP07 DH de Analog Devices.

Le gain de l'ensemble est vérifié par un moyen de test 60 qui délivre une tension de référence. Ce moyen est relié à l'entrée inverseuse de l'amplificateur 48 par l'intermédiaire d'une résistance 61 de très forte valeur et d'un relais à haut isolement.

La chaîne de contre-réaction 50 de l'amplificateur 48 comporte une gamme d'impédance, chacune constituée d'une résistance de très forte valeur et éventuellement d'un condensateur en parallèle. La chaîne de contre-réaction 50 de la figure comprend deux résistances 66 et 70 et deux condensateurs 68 et 72. Le rapport entre les valeurs des deux résistances est important par exemple supérieur à 100.

Les deux impédances sont placées en parallèle et un interrupteur 62 est disposé en série avec la résistance 66 de plus faible valeur. Cet interrupteur est actionné par un relais 64 commandé par le moyen de seuillage de l'appareil par l'intermédiaire de la connexion 42.

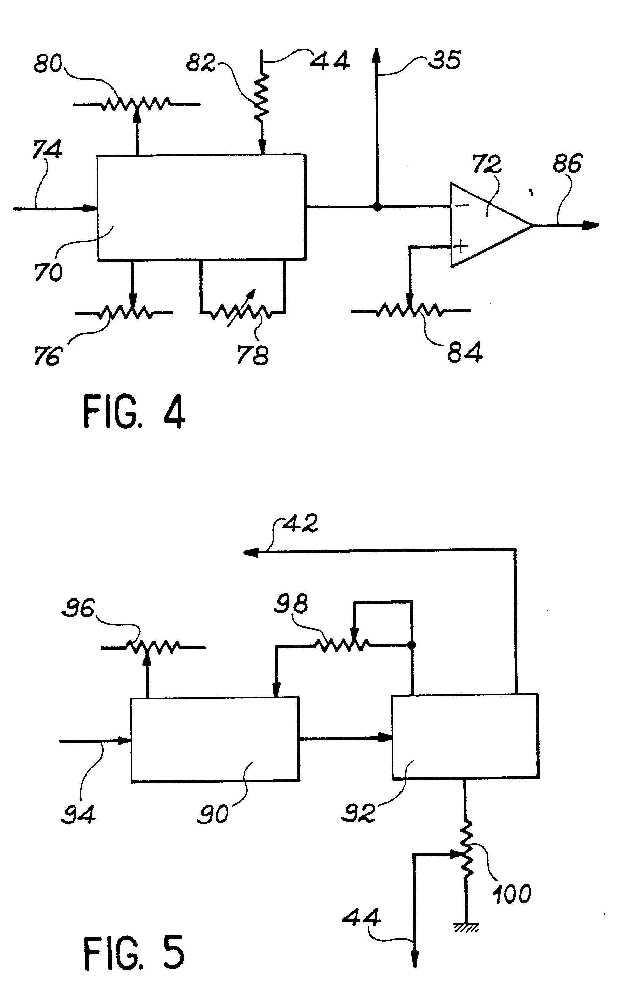

On a représenté sur la figure 4 un mode de réalisation du moyen d'amplification logarithmique de l'appareil de mesure. Il comprend essentiellement un convertisseur logarithmique 70 et un amplificateur de lecture 72.

Le signal délivré par le préamplificateur de la figure précédente est reçu par la connexion 74 par le convertisseur logarithmique 70. Celui-ci comprend des moyens de réglage tels qu'un moyen 76 de réglage du zéro, un moyen 78 de réglage du gain, un moyen 80 de réglage de la première gamme, correspondant à la plus forte résistance de la chaîne de contre-réaction, et un moyen 82 pour délivrer un courant de décalage pour la deuxième gamme, ce moyen étant relié à la connexion 44 issue du moyen de seuillage.

Le signal délivré par le convertisseur logarithmique 70 est délivré au moyen de seuillage par la connexion 35. Selon le niveau de ce signal, le moyen de seuillage commute la gamme d'impédance du préamplificateur sur la faible ou sur la forte sensibilité.

Le signal délivré par le convertisseur logarithmique 70 est également appliqué sur l'entrée inverseuse d'un amplificateur de lecture 72. Cet amplificateur comporte sur son entrée non inverseuse un moyen 84 de réglage du zéro. Il délivre un signal au moyen de lecture par la connexion 86.

A titre d'exemple, le demandeur a réalisé le moyen d'amplification logarithmique de la figure 4 en utilisant comme convertisseur logarithmique le circuit 4127 JG de Burr Brown et comme amplificateur de lecture le circuit LM 301N de National Semiconductor.

La figure 5 représente un mode de réalisation du moyen de seuillage de l'appareil de mesure. Il comprend un circuit 90 de seuil de changement de gamme monté en comparateur à double seuil et un circuit 92 de commande de changement de gamme.

Le circuit 90 reçoit par la connexion 94 le signal délivré par le préamplificateur 32. Il comprend un moyen 96 indicateur de niveau de seuil bas et un moyen 98 indicateur de niveau de seuil haut. Le circuit 92 commande par la connexion 42 le relais de changement de gamme d'impédance du préamplificateur. Il délivre dans une résistance 100 de la connexion 44 un signal au moyen d'amplification logarithmique.

## Revendications

1. Appareil de mesure de courants faibles à grande dynamique comprenant un préamplificateur linéaire (32), un moyen d'amplification logarithmique (34) recevant le signal délivré par le préamplificateur (32), un moyen d'alarme (40) déclenchant un signal lorsque le signal délivré par le moyen d'amplification logarithmique (34) est supérieur à un niveau donné, et un moyen de lecture (36) du signal délivré par le moyen d'amplification logarithmique (34):

– le préamplificateur (32) comprenant une entrée recevant le faible courant à mesurer et une sortie délivrant un signal amplifié fonction de ce courant à mesurer, ledit signal étant appliqué à l'entrée du moyen d'amplification logarithmique (34), caractérisé en ce que le préamplificateur (32) comprend en outre:

– un premier amplificateur (48, 50) dont l'entrée correspond à l'entrée du préamplificateur, ledit amplificateur fournissant la majorité du gain dudit préamplificateur (32), et étant formé d'un amplificateur différentiel (48) doté d'une chaîne de contre-réaction linéaire (50), l'entrée inverseuse de l'amplificateur différentiel (48) étant directement reliée à l'entrée du préamplificateur (32),

– un second amplificateur (52) recevant le signal de sortie du premier amplificateur (48), cet amplificateur étant pour cela placé entre la sortie du premier amplificateur (48) et la sortie du préamplificateur (32) afin d'assurer un rôle de tampon, ce second amplificateur fournissant en outre un gain de quelques unités, la chaîne de contre-réaction linéaire (50) de l'amplificateur différentiel étant à très haute impédance, le second amplificateur étant doté d'une chaîne de contre-réaction linéaire (54) d'impédance beaucoup plus faible,

– un moyen (56, 58) de réglage du zéro et un moyen (60) de test du gain étant en outre prévu sur le premier amplificateur.

2. Appareil selon la revendication 1, caractérisé en ce que la chaîne de contre-réaction (50) du premier amplificateur (48, 50) comporte une gamme d'impédances (66, 70) commutées par un moyen de seuillage (38) recevant en entrée un signal délivré par le moyen d'amplification logarithmique.

3. Appareil selon l'une quelconque des revendications 1 et 2, caractérisé en ce que le moyen de réglage du zéro comporte un moyen de préréglage (56) et un moyen d'ajustage fin (58), ledit moyen d'ajustage fixant le potentiel appliqué sur l'entrée non inverseuse de l'amplificateur différentiel (48).

4. Appareil selon l'une quelconque des revendications 1 à 3, caractérisé en ce que le premier amplificateur (48, 50) est alimenté par une tension inférieure à la tension nominale.

**Claims**

1. Amplifier for measuring low currents with high dynamics incorporating a linear preamplifier (32), a logarithmic amplification means (34) receiving the signal supplied by the preamplifier (32), an alarm means (40) triggering a signal when the signal supplied by the logarithmic amplification means (34) is above a given level and a means (36) for reading the signal supplied by the logarithmic amplification means (34):

– the preamplifier (32) incorporating an input receiving the low current to be measured and an output supplying a signal amplified as a function of the current to be measured, said signal being applied to the input of the logarithmic amplification means (34), characterized in that the preamplifier (32) also comprises:

– a first amplifier (48, 50), whereof the input corresponds to the input of the preamplifier, said amplifier supplying most of the gain of said preamplifier (32), whilst being formed by a differential amplifier (48) having a linear feedback chain (50), the inverting input of the differential amplifier (48) being directly connected to the input of the preamplifier (32),

– a second amplifier (52) receiving the output signal of the first amplifier (48), said amplifier for this purpose being placed between the output of the first amplifier (48) and the output of the preamplifier (32), so as to fulfil a buffer function, said second amplifier also supplying a gain of a few units, the linear feedback chain (50) of the differential amplifier having a very high impedance, the second amplifier having a linear feedback chain (54) with a much lower impedance,

– a means (56, 58) for regulating the zero and a means (60) for testing the gain also being provided on the first amplifier.

2. Apparatus according to claim 1, characterized in that the feedback chain (50) of the first amplifier (48, 50) has a range of impedances (66, 70) switched by a thresholding means (38) receiving at its input a signal supplied by the logarithmic amplification means.

3. Apparatus according to either of the claims 1 and 2, characterized in that the zero regulating means has a preregulating means (56) and a fine adjustment means (58), the latter fixing the potential applied to the non-inverting input of the differential amplifier (48).

4. Apparatus according to any one of the claims 1 to 3, characterized in that the first amplifier (48, 50) is supplied by a voltage below the nominal voltage.

**Patentansprüche**

1. Gerät zum Messen von schwachen Strömen mit hohem Dynamikbereich, enthaltend einen linearen Vorverstärker (32), eine logarithmische Verstärkungseinrichtung (34), die das von dem Vorverstärker (32) abgegebene Signal aufnimmt, eine Alarmeinrichtung (40), die ein Signal auslöst, wenn das von der logarithmischen Verstärkungseinrichtung (34) abgegebene Signal über einem vorgegebenen Pegel liegt, und eine Leseeinrichtung (36) für das von der logarithmischen Verstärkungseinrichtung (34) abgegebene Signal:

wobei der Vorverstärker (32) einen Eingang aufweist, der den zu messenden schwachen Strom aufnimmt, und einen Ausgang aufweist, der ein verstärktes Signal abgibt, das von dem zu messenden Strom abhängig ist, welches Signal dem Eingang der logarithmischen Verstärkungseinrichtung (34) zugeführt wird, dadurch gekennzeichnet, daß der Vorverstärker (32) weiterhin enthält:

einen ersten Verstärker (48, 50), dessen Eingang dem Eingang des Vorverstärkers entspricht, welcher Verstärker den Großteil der Verstärkung des genannten Vorverstärkers (32) liefert und der von einem Differenzverstärker (48) gebildet ist, der mit einer linearen Gegenkopplungskette (50) versehen ist, wobei der invertierende Eingang des Differenzverstärkers (48) direkt mit dem Eingang des Vorverstärkers (32) verbunden ist, einen zweiten Verstärker (52), der das Ausgangssignal des ersten Verstärkers (48) aufnimmt, wobei dieser Verstärker hierfür zwischen dem Ausgang des ersten Verstärkers (48) und dem Ausgang des Vorverstärkers (32) angeordnet ist, um die Rolle eines Puffers zu übernehmen, wobei dieser zweite Verstärker weiterhin eine Verstärkung von einigen Einheiten liefert, die lineare Gegenkopplungskette (50) des Differenzverstärkers eine sehr hohe Impedanz aufweist, der zweite Verstärker mit einer linearen Gegenkopplungskette (54) sehr viel geringerer Impedanz versehen ist, eine Nullregeleinrichtung (56, 58) und eine Testeinrichtung (60) für die Verstärkung, die weiterhin am ersten Verstärker vorgesehen sind.

2. Gerät nach Anspruch 1, dadurch gekennzeichnet, daß die Gegenkopplungskette (50) des ersten Verstärkers (48, 50) eine Reihe von Impe-danzen (66, 70) aufweist, die von einer Schwelleneinrichtung umgeschaltet wird, die am Eingang ein Signal empfängt, das von der logarithmischen Verstärkungseinrichtung abgegeben wird.

3. Gerät nach einem der Ansprüche 1 und 2, dadurch gekennzeichnet, daß die Nullregeleinrichtung eine Vorregeleinrichtung (56) und eine Feineinstelleinrichtung (58) enthält, welche Einstelleinrichtung das Potential festlegt, das am nicht-invertierenden Eingang des Differenzverstärkers (48) anliegt.

4. Gerät nach einem der Ansprüche 1 bis 3, dadurch gekennzeichnet, daß der erste Verstärker (48, 50) mit einer Spannung versorgt wird, die niedriger als die Nominalspannung ist.

FIG. 1

EP 0 155 197 B1

FIG. 2

FIG. 3

80    82    44    35

74

70    76    78    84

# FIG. 4

42

96    98

94    90    92    44    100

# FIG. 5